# EUROPEAN PATENT APPLICATION

(11) **EP 4 848 907 A1**
(43) Date of publication of application: **02.12.2026**
(21) Application number: 26707403.7
(22) Date of filing: 13.02.2026
(51) Int. Cl.: H05K 1/02

(54) **FLEXIBLE PRINTED CIRCUIT BOARD COMPRISING COATING LAYER AND ELECTRONIC DEVICE COMPRISING SAME**

(30) Priority: 31.03.2025 KR 20250041818; 02.06.2025 KR 20250072494
(71) Applicant: Samsung Electronics Co., Ltd, Suwon-si, Gyeonggi-do 16677 (KR)
(72) Inventor: LEE, Youngsun, Suwon-si, Gyeonggi-do 16677 (KR); CHO, Chihyun, Suwon-si, Gyeonggi-do 16677 (KR); LIM, Dongeon, Suwon-si, Gyeonggi-do 16677 (KR); LEE, Eunho, Suwon-si, Gyeonggi-do 16677 (KR); LEE, Deokhee, Suwon-si, Gyeonggi-do 16677 (KR); SONG, Yongjae, Suwon-si, Gyeonggi-do 16677 (KR); PARK, Jinwoo, Suwon-si, Gyeonggi-do 16677 (KR); PARK, Sungwon, Suwon-si, Gyeonggi-do 16677 (KR)
(74) Representative: HGF
(86) International application number: PCT/KR2026/002795
(87) International publication number: WO 2026/212163

(57) **Abstract**

An electronic device is disclosed. The electronic device may include a foldable housing including a first housing part and a second housing part rotatable with respect to the first housing part, and a flexible printed circuit board (FPCB) including a bending portion configured to bend when the foldable housing is folded. The bending portion may include a coating layer. The bending portion may define at least one surface of a first surface and a second surface of the FPCB and the coating layer, and may include an elastic material extending according to a designated pattern. The coating layer may be included on the bending portion of the FPCB in a location which is contactable with an internal structure of the electronic device by the folding or unfolding of the foldable housing.

## Description

### [Technical Field]

The following descriptions relate to a flexible printed circuit board including a coating layer and an electronic device including the same.

### [Background Art]

An electronic device may include housing parts that are rotatably coupled to one another, and a flexible display. As the housing parts rotate with respect to each other, a portion of the flexible display may be bent.

A foldable electronic device may include a first housing, a second housing, and a hinge structure disposed between the first housing and the second housing. The hinge structure may allow the first housing to rotate (or fold) with respect to the second housing, and may couple the first housing to the second housing. The foldable electronic device may include a connection member extending from the first housing to the second housing across the hinge structure to connect electronic components disposed respectively inside the first housing and the second housing to each other.

The connection member may include a flexible printed circuit board (FPCB) that is bendable.

The above-described information may be provided as a related art for a purpose of helping understanding of the present disclosure. No claim or determination is raised as to whether any of the above-described descriptions may be applied as a prior art related to the present disclosure.

### [Disclosure]

### [Technical Solution]

An electronic device is disclosed. The electronic device may include a foldable housing including a first housing part and a second housing part rotatable with respect to the first housing part, and a flexible printed circuit board (FPCB) including a bending portion configured to bend when the foldable housing is folded. The bending portion may include a coating layer. The bending portion may define at least one surface of a first surface and a second surface of the FPCB and the coating layer, and may include an elastic material extending according to a designated pattern. The coating layer may be included on the bending portion of the FPCB in a location which is contactable with an internal structure of the electronic device by the folding or unfolding of the foldable housing.

### [Description of the Drawings]

In association with description of a drawing, the same or similar reference numerals may be used for the same or similar components.
FIG. 1 is a block diagram of an electronic device in a network environment according to various embodiments.
FIG. 2A illustrates an unfolded state of an exemplary electronic device.
FIG. 2B illustrates a folded state of an exemplary electronic device.
FIG. 3 illustrates a rear surface of an electronic device according to an embodiment.
FIG. 4A illustrates an electronic device in a state of being unfolded, according to an embodiment.
FIGS. 4B and 4C illustrate an electronic device in a state of being folded, according to an embodiment.
FIG. 4D illustrates an electronic device in a state of being fully folded, according to an embodiment.
FIG. 5 is a plan view of a flexible printed circuit board (FPCB) according to an embodiment.
FIG. 6 is an enlarged view of an FPCB according to an embodiment.
FIG. 7A is a cross-sectional view cut along line B-B' of FIG. 6.
FIGS. 7B to 7E are an enlarged view of FIG. 7A.
FIG. 8A is a diagram exemplifying a location where a protective layer is disposed in an FPCB, according to an embodiment.
FIG. 8B is a diagram exemplifying a location where a protective layer is disposed in an FPCB, according to an embodiment.
FIGS. 9A to 9C are a diagram exemplifying a pattern of a protective layer in an FPCB, according to an embodiment.
FIG. 10 is a diagram indicating an example of an electronic device to which an FPCB having a protective layer is applied, according to an embodiment.
FIG. 11 is a diagram indicating an example of an electronic device to which an FPCB having a protective layer is applied, according to an embodiment.
FIGS. 12A and 12B are a diagram indicating an example of an electronic device in which a protective layer is applied to a region other than an FPCB, according to an embodiment.

### [Mode for Invention]

Hereinafter, an embodiment of the present disclosure will be described in detail with reference to a drawing such that those having ordinary knowledge in the art to which the present disclosure belongs may easily implement the present disclosure. However, the present disclosure may be implemented in several different forms and is not limited to the embodiment described herein. In association with a description of the drawing, the same or similar reference numerals may be used for the same or similar components. In addition, in the drawing and the associated description, a description of well-known functions and configurations may be omitted for clarity and brevity.

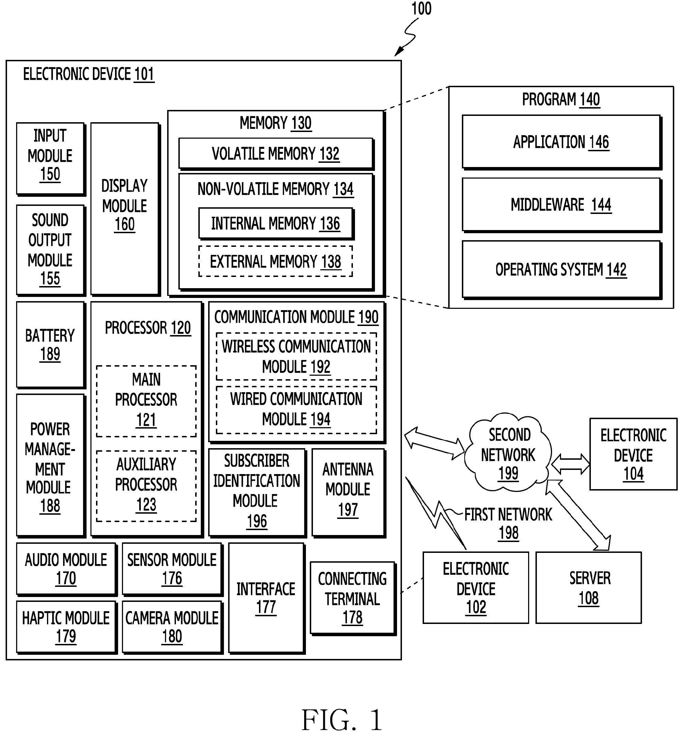

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

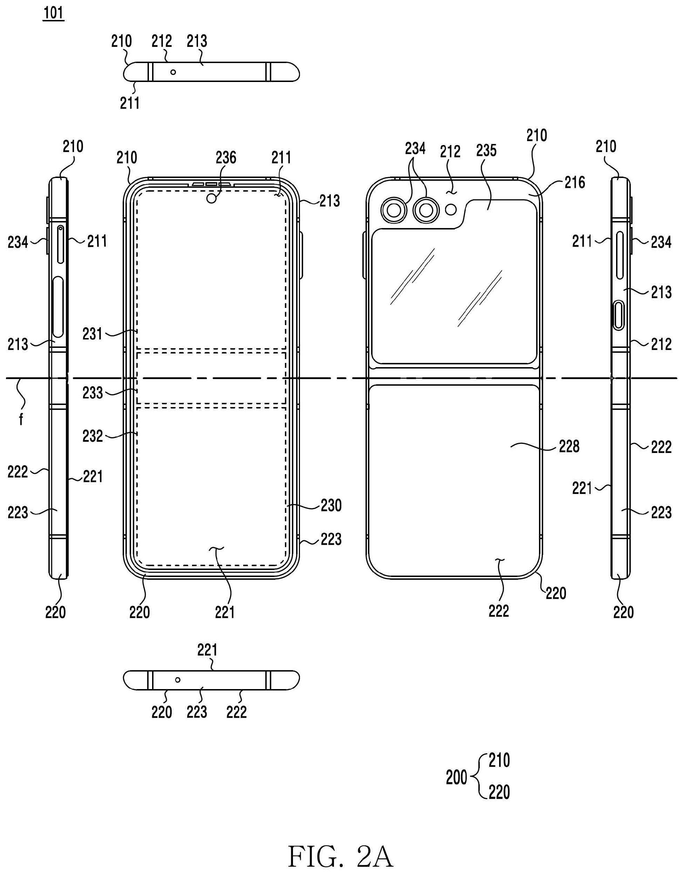

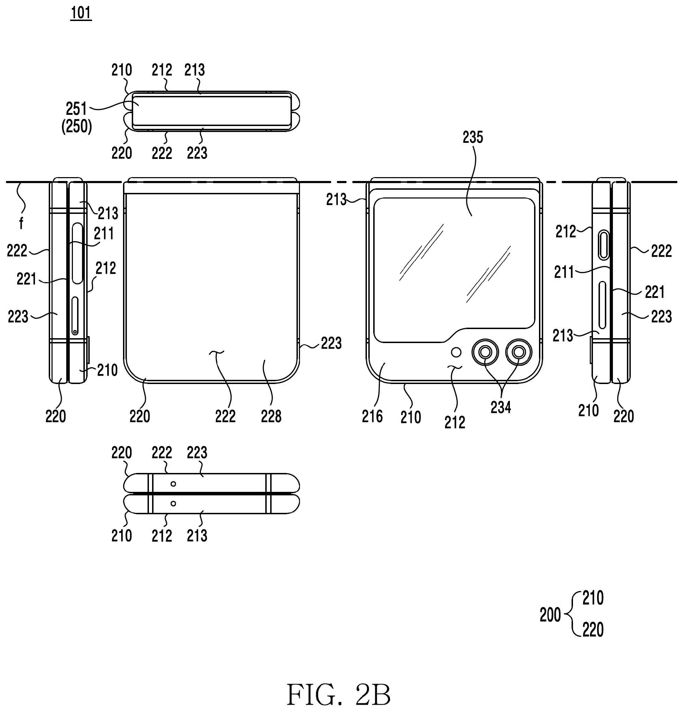

FIG. 2A illustrates an unfolded state of an exemplary electronic device. FIG. 2B illustrates a folded state of an exemplary electronic device.

An electronic device 101 exemplarily illustrated and described in FIGS. 2A and 2B may be referred to as a foldable electronic device in terms of including a display 230 including a foldable portion 233 that is deformable by a hinge structure 250 (or a hinge assembly) configured to rotate, or allow the rotation of, a second housing part 220 with respect to a first housing part 210.

The electronic device 101 may include a housing 200 including the first housing part 210 and the second housing part 220, and the hinge structure (or the hinge assembly) 250. The first housing part 210 may be rotatably connected to the hinge structure 250. The first housing part 210 may rotate with respect to the second housing part 220 through the hinge structure 250. The second housing part 220 may be rotatably connected to the hinge structure 250. The second housing part 220 may rotate with respect to the first housing part 210 through the hinge structure 250. In various examples, the first housing part 210 and the second housing part 220 may be regarded as rotatably coupled to one another without the need to specify the hinge structure 250. That is, it is envisaged that the rotatably coupled arrangement of the first housing part 210 and the second housing part 220 may be implemented without a dedicated hinge structure, in various embodiments.

The first housing part 210 may include a first front surface 211, a first rear surface 212 faced away from the first front surface 211, and first side surfaces 213 covering at least a portion of the first front surface 211 and the first rear surface 212. The first housing part 210 may provide a space for disposing components of the electronic device 101. The first housing part 210 may include a conductive material, a non-conductive material, or a combination thereof. The first housing part 210 may include a first cover 216 disposed on the first rear surface 212. The first cover 216 may define a portion of an outer surface of the first housing part 210.

The second housing part 220 may include a second front surface 221, a second rear surface 222 faced away from the second front surface 221, and second side surfaces 223 covering at least a portion of the second front surface 221 and the second rear surface 222. The second housing part 220 may provide a space for disposing components of the electronic device 101. The second housing part 220 may include a second cover 228 disposed on the second rear surface 222. The second cover 228 may define a portion of an outer surface of the second housing part 220.

The hinge structure 250 may be connected to the first housing part 210 and the second housing part 220, respectively. For example, the hinge structure 250 may include a first hinge plate and a second hinge plate, which are rotatably configured. The first hinge plate may be connected to the first housing part 210, and the first housing part 210 may be rotated by the first hinge plate. The second hinge plate may be connected to the second housing part 220, and the second housing part 220 may be rotated by the second hinge plate.

According to the rotation of the first housing part 210 and the second housing part 220, the electronic device 101 may be folded or unfolded based on a folding axis f passing through the hinge structure 250. The hinge structure 250 may be located between the first housing part 210 and the second housing part 220 such that the electronic device 101 may be folded based on the folding axis f.

The hinge structure 250 may include a hinge cover 251 for covering an internal structure configuring a mechanism of the hinge structure. According to a degree to which the electronic device 101 is folded, the hinge cover 251 may be exposed to the outside, or may be covered by the first housing part 210 and the second housing part 220. For example, while the electronic device 101 is in a folded state (e.g., FIG. 2B), the hinge cover 251 may be at least partially exposed through between the first housing part 210 and the second housing part 220. For example, while the electronic device 101 is in an unfolded state (e.g., FIG. 2A), the hinge cover 251 may be covered by the first housing part 210 and the second housing part 220.

The electronic device 101 may include a display 230 (e.g., the display module 160 of FIG. 1) disposed in a space provided by the first housing part 210 and the second housing part 220. For example, the display 230 may be at least partially accommodated in a recess formed in the first front surface 211 of the first housing part 210 and the second front surface 221 of the second housing part 220. The display 230 may include a first flat portion 231 aligned with respect to the first housing part 210, a second flat portion 232 spaced apart from the first flat portion 231 and aligned with respect to the second housing part 220, and the foldable portion 233 aligned with respect to the hinge structure 250 and extending from the first flat portion 231 to the second flat portion 232. The display 230 may be referred to as a foldable display or a flexible display. The first flat portion 231, the second flat portion 232, and the foldable portion 233 may form a surface of the display 230. The surface of the display 230 may at least partially form the first front surface 211 of the first housing part 210 and the second front surface 221 of the second housing part 220. The first flat portion 231, the second flat portion 232, and the foldable portion 233 may respectively define a first display area, a second display area, and a third display area of the display 230 on which visual information may be displayed.

The electronic device 101 may include a sub-display 235 (e.g., the display module 160 of FIG. 1) disposed in the first housing part 210. The sub-display 235 may be visible through the first rear surface 212 of the first housing part 210.

The electronic device 101 may include a plurality of cameras (e.g., the camera module 180 of FIG. 1). For example, the electronic device 101 may include cameras 234 and 236. The camera 234 may be disposed in the first housing part 210 to obtain an image through a portion of the first rear surface 212. The camera 236 may be disposed below the first flat portion 231 of the display 230. The camera 236 may be aligned with an opening at least partially penetrating the first flat portion 231, and may obtain an image through the hole. The camera 236 may be located within a screen display area of the display 230, but is not limited thereto.

Hereinafter, states of the electronic device 101 will be described. The electronic device 101 may include a plurality of states including the unfolded state (e.g., FIG. 2A) and the folded state (e.g., FIG. 2B). The electronic device 101 may be transformed or changed in the unfolded state and the folded state. In addition, the electronic device 101 may include a plurality of intermediate states between the unfolded state and the folded state. An angle between the first housing part 210 and the second housing part 220 may vary according to a state of the electronic device 101. The plurality of states may also include an intermediate state, this term covering states between the unfolded state and the folded state. An intermediate state may also be regarded as a partially open state, a partially closed state, a partially unfolded state or a partially folded state.

Referring to FIG. 2A, in the unfolded state, the first housing part 210 and the second housing part 220 may form a first angle. For example, the first angle may be approximately 180 degrees. The first flat portion 231, the second flat portion 232, and the foldable portion 233 of the display 230 may form one substantially flat surface, e.g. they are planar (or substantially so) with one another. A direction in which the first front surface 211 (or the first flat portion 231) of the first housing part 210 faces and a direction in which the second front surface 221 (or the second flat portion 232) of the second housing part 220 faces may be substantially the same.

Referring to FIG. 2B, in or from the unfolded state of the electronic device 101, the first housing part 210 and the second housing part 220 may be folded to face each other by rotating based on the folding axis f. The first housing part 210 and the second housing part 220 may be stacked with each other to form a second angle smaller than the first angle. For example, the second angle may be approximately 0 degrees. The foldable portion 233 of the display 230 may be bent to correspond to the second angle. For example, the foldable portion 233 may be bent back on itself in the folded state. The first front surface 211 of the first housing part 210 may face the second front surface 221 of the second housing part 220 or may overlap the second front surface 221. The first housing part 210 and the second housing part 220 may at least partially contact each other, but it is not limited thereto. The direction in which the first front surface 211 of the first housing part 210 faces and the direction in which the second front surface 221 of the second housing part 220 faces may be opposite to each other. In the folded state, at least a portion of the display 230 may not be visible outside the electronic device 101, and the sub-display 235 may be visible outside the electronic device 101. While the folded state has been described with reference to the first front surface 211 of the first housing part 210 (or at least a portion thereof) facing the second front surface 221 of the second housing part 220, the present disclosure also considers and includes electronic devices having a folded state in which the first rear surface 212 and the second rear surface 222 face each other. For such an electronic device, for example, in the folded state the display 230 may be visible to outside of the electronic device while the sub-display 235 is not visible to outside of the electronic device.

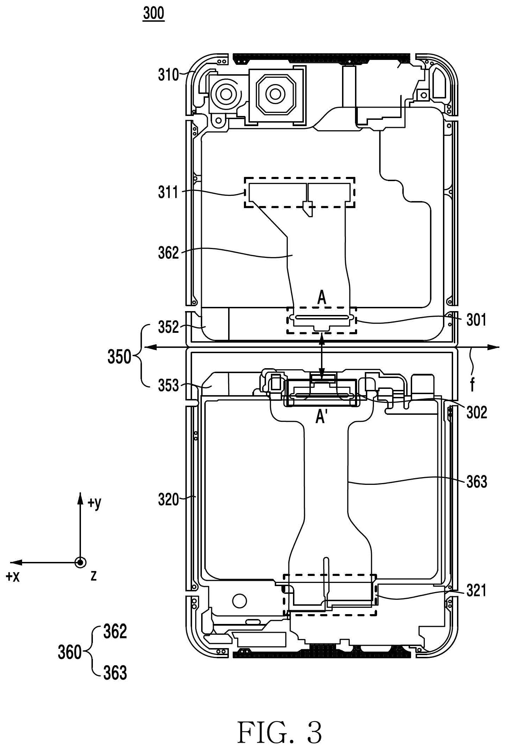

FIG. 3 illustrates a rear surface of an electronic device according to an embodiment.

FIG. 3 is a front view of an electronic device 300 from which a display (e.g., the display 230 of FIG. 2A) and a rear cover are removed. Referring to FIG. 3, the electronic device 300 according to an embodiment may include a hinge structure 350 (e.g., the hinge structure 250 of FIG. 2B) and a flexible printed circuit board (FPCB) 360.

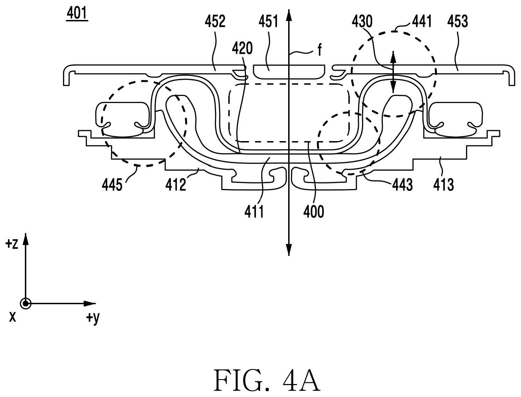

For example, the hinge structure 350 of the electronic device 300 may include a first support member 352 (or a first portion 352) and a second support member 353 (or a second portion 353). In an embodiment, rotating structures (e.g., gears) for rotation of the first support member 352 and the second support member 353 of the hinge structure 350 may be at least partially disposed in an inner space (e.g., the space 400 of FIG. 4A) provided by a hinge cover (e.g., 251 of FIG. 2B). The gears may facilitate rotation of the first support member 352 relative to the second support member 353.

In an embodiment, the FPCB 360 of the electronic device 300 may extend from a first housing part 310 to a second housing part 320. In an embodiment, the FPCB 360 may extend from the first housing part 310 to the second housing part 320 beyond (e.g. across, or over) the hinge structure 350 disposed between the first housing part 310 and the second housing part 320. In an embodiment, the FPCB 360 may extend from the first housing part 310 to the second housing part 320 across a foldable portion (e.g., 233 of FIG. 2A) of the display.

In an embodiment, the FPCB 360 may extend from the first housing part 310 to the second housing part 320 by passing through a first through-hole 301 and a second-through hole 302 of (or formed in) the hinge structure 350. For example, the FPCB 360 may pass through the first-through hole 301 and the second-through hole 302 in order while extending from the first housing part 310 to the second housing part 320.

In an embodiment, the FPCB 360 may electrically connect a first printed circuit board disposed in the first housing part 310 and a second printed circuit board disposed in the second housing part 320 to each other. For example, the FPCB 360 may include first connector portions 311 located in the first housing part 310 and connected to the first printed circuit board, and second connector portions 321 located in the second housing part 320 and connected to the second printed circuit board. In an embodiment, components (e.g., the processor 120 of FIG. 1) disposed on the first printed circuit board and components (e.g., the connection terminal 178 of FIG. 1 or the sound output module 155 of FIG. 1) connected to the second printed circuit board may be operatively or electrically connected to each other through the FPCB 360.

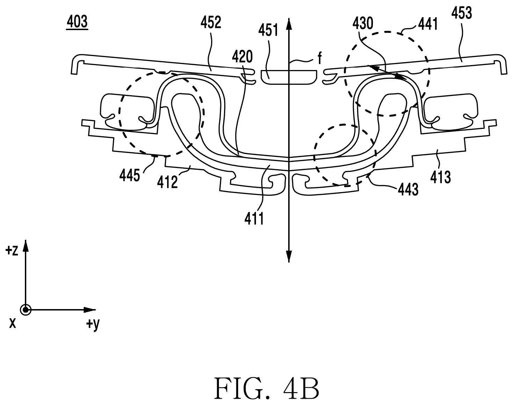

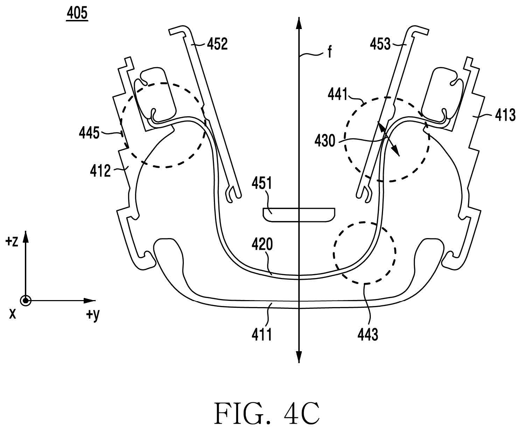

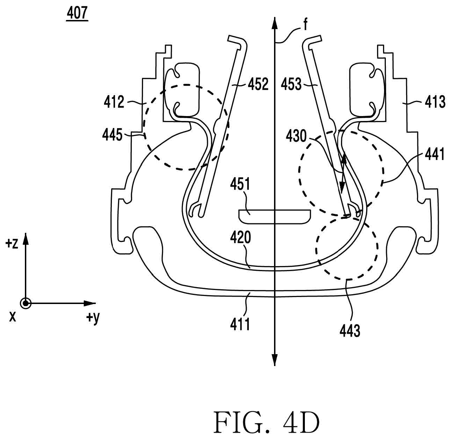

FIG. 4A illustrates an electronic device in a state of being unfolded, according to an embodiment. FIGS. 4B and 4C illustrate an electronic device in a state of being folded, according to an embodiment. FIG. 4D illustrates an electronic device in a state of being fully folded, according to an embodiment.

FIG. 4A may be a cross-sectional view of the electronic device 300 of FIG. 3 cut in a direction (e.g., a +y-axis direction) perpendicular to a folding axis f.

Referring to FIG. 4A, the electronic device 300 may include a first support member 412 and a second support member 413. In an embodiment, the first support member 412 may be included as a portion in a first housing part (e.g., 310 of FIG. 3). In an embodiment, the second support member 413 may be included as a portion in a second housing part (e.g., 320 of FIG. 3).

In an embodiment, a first rotating structure having a hinge structure (e.g., 250 of FIG. 2B) may be connected to the first support member 412. In an embodiment, the first support member 412 connected to the first rotating structure may rotate around a folding axis.

In an embodiment, a second rotating structure having the hinge structure (e.g., 250 of FIG. 2B) may be connected to the second support member 413. In an embodiment, the second support member 413 connected to the second rotating structure may rotate around the folding axis.

In an unfolded state 401 of FIG. 4A, a hinge cover 411 may be covered by the first housing part 310 (or the first support member 412) and the second housing part 320 (or the second support member 413). In partially folded states 403 and 405 (or partially unfolded states, or intermediate states) of FIGS. 4B and 4C, at least a portion of the hinge cover 411 may form a surface of the electronic device 300. In the partially folded states 403 and 405 (or the partially unfolded states) of FIGS. 4B and 4C, the at least a portion of the hinge cover 411 may be exposed from the first housing part 310 (or the first support member 412) and the second housing part 320 (or the second support member 413). This exposure may arise through movement, i.e. rotation, of the first support member 412 and the second support member 413 (or the first housing part 310 and the second housing part 320) in switching from the unfolded state to an intermediate state or the folded state. In a folded state 407 of FIG. 4D (i.e. a fully folded state), at least a portion of the hinge cover 411 may be exposed from the first housing part 310 (or the first support member 412) and the second housing part 320 (or the second support member 413). In the fully folded state 407 of FIG. 4D, an extent in which the hinge cover 411 is exposed to the outside may be wider than an extent in which the hinge cover 411 is exposed to the outside in the partially folded states 403 and 405 of FIGS. 4B and 4C.

Referring to FIG. 4A, the electronic device 300 according to an embodiment may include a first hinge plate 452, a second hinge plate 453, and a center plate 451. The first hinge plate 452 and the second hinge plate 453 may be described as a first wing plate and a second wing plate, respectively. The center plate 451 may have a bar shape extending parallel to the folding axis f of the electronic device 300. In this respect, the center plate 451 may be described as a center bar.

The first hinge plate 452, the second hinge plate 453, and the center plate 451 may be disposed below the display (230 of FIG. 2A) (e.g., in a -z-axis direction). The first hinge plate 452 and the second hinge plate 453 may be attached below the display 230. For example, the display 230 may be directly or indirectly attached to the first hinge plate 452 and the second hinge plate 453.

In the state 401 in which the electronic device 300 is fully unfolded, the center plate 451 may be located between the first hinge plate 452 and the second hinge plate 453. For example, in the unfolded state in which a surface of the display 230 is substantially flat (e.g. the first flat portion 231, the second flat portion 232, and the foldable portion 233 of the display 230 form one substantially flat surface), the center plate 451 is located between the first hinge plate 452 and the second hinge plate 453.

Referring to FIGS. 4B to 4D, in the states 403, 405, and 407 of the electronic device 300, each of the first hinge plate 452 and the second hinge plate 453 may rotate in a direction in which the electronic device 300 is folded. That is, the first hinge plate 452 and the second hinge plate 453 rotate about the folding axis as the electronic device 300 is folded. For example, when the electronic device 300 is folded, each of the first hinge plate 452 and the second hinge plate 453 may rotate toward each other. The center plate 451 may not move (e.g. not rotate) regardless of the folding or unfolding of the electronic device 300.

In the states 403, 405, and 407 of the electronic device 300, the display 230 may be bent in a space defined by the first hinge plate 452, the second hinge plate 453, and the center plate 451. For example, when the electronic device 300 is folded, the first hinge plate 452, the second hinge plate 453, and the center plate 451 may bend the display 230 (or cause the display 230 to bend) into a designated shape (e.g., a U shape or a water drop shape).

In an embodiment, in the unfolded state 401 of the electronic device 300, the FPCB 420 of the electronic device 300 may be disposed below the first hinge plate 452, the second hinge plate 453, and the center plate 451 (e.g., in the -z-axis direction). In an embodiment, in the unfolded state 401 of the electronic device 300, the FPCB 420 may be disposed above the first support member 412 and the second support member 413 (e.g., in a +z-axis direction). In an embodiment, in the unfolded state 401 of the electronic device 300, the FPCB 420 may be disposed above the hinge cover 411 (e.g., in the +z-axis direction).

In an embodiment, in the states 401, 403, 405, and 407 of the electronic device 300, the FPCB 420 of the electronic device 300 may be in contact with instruments or components (e.g., the first hinge plate 452, the second hinge plate 453, the first support member 412, the second support member 413, and/or the hinge cover 411) in one or more portions 441, 443, and 445. As the one or more portions 441, 443, and 445 of the FPCB 420 are in contact with the instruments, the FPCB 420 may partially bend (e.g. may be configured to have one or more bent portions along its length). Hereinafter, the one or more portions 441, 443, and 445 of the FPCB 420 may be referred to as curved portions. Herein, the instruments or components (e.g., the first hinge plate 452, the second hinge plate 453, the first support member 412, the second support member 413, and/or the hinge cover 411) may be generally referred to as an internal structure (or portion thereof) of the electronic device 300 (e.g. including a hinge structure 350 and/or a support structure such as may include first support member 412 and second support member 413).

Between the unfolded state 401 and the folded state 407 of the electronic device 300, as the first housing part 310 (or the first support member 412) of the electronic device 300 rotates with respect to the second housing part 320 (or the second support member 413), a location of the one or more portions 441, 443, and 445 of the FPCB 420 in contact with the instruments may be moved. For example, between the unfolded state 401 and the folded state 407 of the electronic device 300, rotation angles of the first hinge plate 452 and the second hinge plate 453 may be greater than rotation angles of the first support member 412 and the second support member 413. Accordingly, the location of the one or more portions 441, 443, and 445 of the FPCB 420 in contact with the instruments may be moved. It may instead be considered that the portions of the FPCB 420 defining the one or more portions 441, 443, 445 change as the first housing part 310 rotates with respect to the second housing part 320; in other words, previously-bent portions are straightened while previously-straight portions are bent, as the electronic device 300 moves between the unfolded state 401 and the folded state 407.

In addition, in the states 401, 403, 405, and 407 of the electronic device 300, shear stress and/or compressive stress may be applied to the FPCB 420 as the FPCB 420 of the electronic device 300 is in contact with the instruments (e.g., the first hinge plate 452, the second hinge plate 453, the first support member 412, the second support member 413, and the hinge cover 411) in the one or more portions 441, 443, and 445. In addition, for example, between the unfolded state 401 and the folded state 407 of the electronic device 300, a direction of stress 430 in the portion 441 of the FPCB 420, which is generated by contacting of the second hinge plate 453, may be changed as the first housing part 310 (or the first support member 412) rotates with respect to the second housing part 320 (or the second support member 413).

Accordingly, the FPCB 420 of the electronic device 300 may be attached to the instruments (e.g., the first hinge plate 452, the second hinge plate 453, the first support member 412, the second support member 413, and the hinge cover 411) in the one or more portions 441, 443, and 445 via an adhesive material (e.g., a double-sided tape). However, in a case that the FPCB 420 is attached to the instruments via the adhesive material, the FPCB 420 may be detached from the instruments as the first housing part 310 (or the first support member 412) rotates with respect to the second housing part 320 (or the second support member 413).

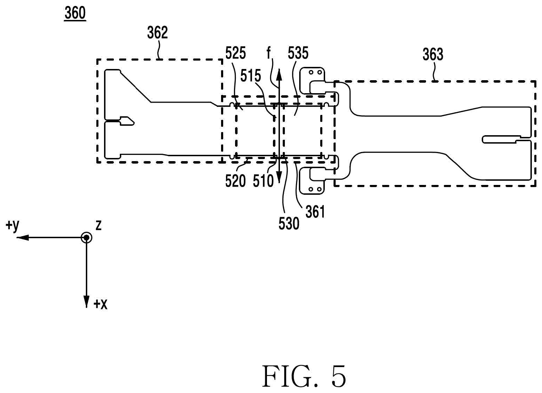

For these reasons, the FPCB 420 may deteriorate due to contacting the instruments as the first housing part 310 (or the first support member 412) of the electronic device 300 rotates with respect to the second housing part 320 (or the second support member 413). Therefore, modifications to a structure of the FPCB 420 may be required to reduce the deterioration of the FPCB 420 due to the instruments. Hereinafter, a structure of the FPCB 420 for reducing the deterioration of the FPCB 420 due to the instruments (e.g. due to contact with components in a folding region of the electronic device 300) according to various embodiments of the present disclosure is described with reference to FIGS. 5 to 9C. It is to be understood that FIGS. 5 to 9C illustrate features and concepts of various embodiments but should not be seen to limit the overall disclosure, as FIGS. 5 to 9C may include optional features which could be omitted from other embodiments.

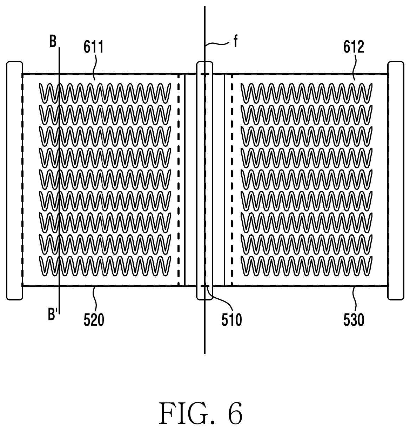

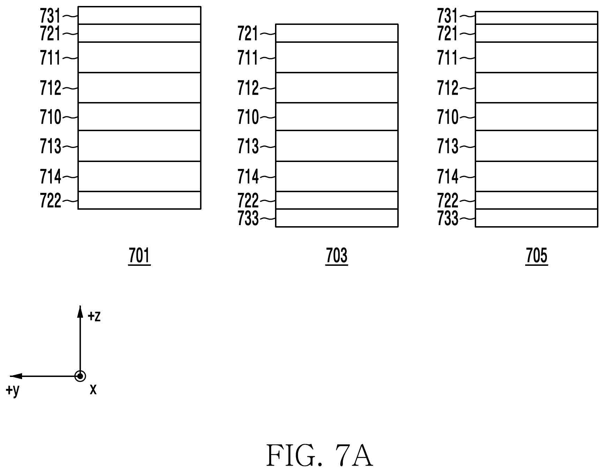

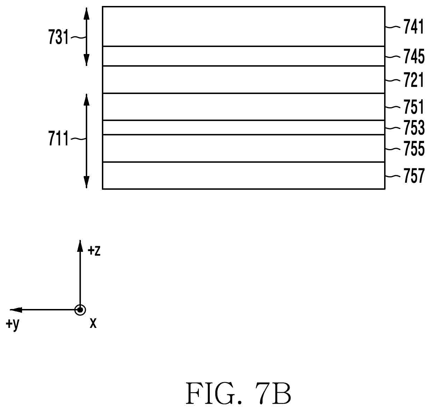

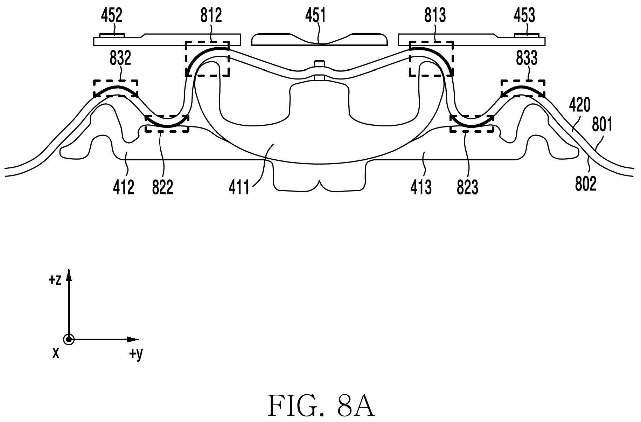

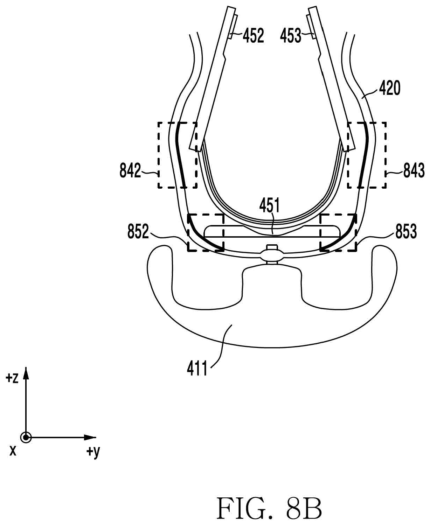

FIG. 5 is a plan view of an FPCB according to an embodiment. FIG. 6 is an enlarged view of an FPCB according to an embodiment. FIG. 7A is a cross-sectional view cut along line B-B' of FIG. 6. FIGS. 7B to 7E are an enlarged view of FIG. 7A. FIG. 8A is a diagram exemplifying a location where a protective layer is disposed in an FPCB, according to an embodiment. FIG. 8B is a diagram exemplifying a location where a protective layer is disposed in an FPCB, according to an embodiment.

Referring to FIG. 5, an FPCB 360 according to an embodiment may include a first portion 361, a second portion 362, and a third portion 363.

In an embodiment, the first portion 361 of the FPCB 360 may include a portion disposed in a hinge structure (e.g., 350 of FIG. 3). For example, the first portion 361 of the FPCB 360 may include a portion that passes through a first-through hole (e.g., 301 of FIG. 3) and a second- through hole (e.g., 302 of FIG. 3) and is disposed below the hinge structure 350. For example, the first portion 361 may correspond to a portion of the FPCB 360 between first and second through-holes (e.g. 301 and 302 of FIG. 3), with the FPCB 360 being arranged to pass through both first and second through-holes. For example, the first portion 361 of the FPCB 360 may include a portion where a center plate (e.g., 451 of FIG. 4A) and the FPCB 360 overlap.

In an embodiment, the second portion 362 of the FPCB 360 may include a portion disposed in a first housing part (e.g., 310 of FIG. 3). In an embodiment, the second portion 362 of the FPCB 360 may include a portion electrically connected to a first printed circuit board of a first housing part 310. The second portion 362 may meet (or transition to) the first portion 361 at one of the first and second through-holes (e.g. one of 301 and 302 of FIG. 3).

In an embodiment, the third portion 363 of the FPCB 360 may include a portion disposed in a second housing part (e.g., 320 of FIG. 3). In an embodiment, the third portion 363 of the FPCB 360 may include a portion electrically connected to a second printed circuit board of a second housing part 320. The third portion 363 may meet (or transition to) the first portion 361 at the other one of the first and second through-holes (e.g. the other one of 301 and 302 of FIG. 3).

In an embodiment, between an unfolded state (e.g., 401 of FIG. 4A) and a folded state (e.g., 407 of FIG. 4D) of the electronic device 300, the first portion 361 may include a bending portion (or a plurality of bending portions) bending as the first housing part 310 (or a first support member (e.g., 412 of FIG. 4A)) of an electronic device 300 rotates with respect to the second housing part 320 (or a second support member (e.g., 413 of FIG. 4A)).

In an embodiment, at least one surface among surfaces of the first portion 361 (or the bending portion) of the FPCB 360 may be coated with a designated material. For example, the designated material may include a polymer (or polymer) material. For example, the designated material may include a material with wear resistance (or with a low coefficient of friction) (or with low elongation). For example, the designated material may include a material with elasticity. For example, the designated material may include polytetrafluoroethylene (PTFE), urethane (or polyurethane), or Fluorinated Polyurethane. However, an embodiment is not limited thereto. The designated material may include a hydrophobic (or water repellent) coating agent (e.g., a mixture of hydrofluoroether (HFE) and a fluorine-based acrylic polymer). For example, the first portion 361 may include a surface layer of designated material.

In an embodiment, the designated material may be coated on at least one surface of the surfaces of the first portion 361 (or the bending portion) of the FPCB 360 in contact with (or which may be brought into contact with, e.g. by folding of the electronic device 300) an instrument (e.g., a first hinge plate (452 of FIG. 4A), a second hinge plate (453 of FIG. 4A), the first support member (412 of FIG. 4A), the second support member (413 of FIG. 4A), and a hinge cover (411 of FIG. 4A)). Hereinafter, the portion of the FPCB 360 coated with the designated material may be referred to as coating layer 525 or 535.

In an embodiment, the coating layer 525 or 535 coated on at least one surface of the FPCB 360 may extend in a direction (e.g., a y-axis direction) perpendicular to a folding axis f. In an embodiment, the coating layer 525 or 535 coated on the at least one surface of the FPCB 360 may be formed in a designated pattern. For example, referring to FIG. 6, the designated pattern may be a pattern in which a plurality of lines 611 and 612 arranged in a direction (e.g., an x-axis direction) parallel to the folding axis f extend in a direction (e.g., the y-axis direction) perpendicular to the folding axis f in a meander or meandering line pattern (or a wave pattern, or a sinusoidal pattern, or an undulating pattern, or an oscillating pattern). However, an embodiment is not limited thereto. For example, the coating layer 525 or 535 coated on the at least one surface of the FPCB 360 may be formed in a pattern in which designated shapes or figures (e.g., a circle and a polygon) are repeated. According to various embodiments, each of the plurality of lines 611 and 612 has the same shape, e.g. if the lines 611 and 612 are seen as a wave pattern, each line has a waveform with the same periodicity and amplitude values. According to other embodiments, different lines among the plurality of lines 612 and 613 have different shapes, e.g. meander to different extents or, in the case of being viewed as a wave pattern, different lines have waveforms with different periodicities and/or amplitude values.

For example, when the FPCB 360 is viewed from above (e.g., when viewed in a z-axis direction), the coating layer 525 or 535 may be discontinued in a third section 510 that intersects the folding axis f. For example, the coating layer 525 or 535 may be discontinued in the third section 510 intersecting the folding axis f among the portion where the center plate 451 and the FPCB 360 overlap. For example, in a layer 515 in the third section 510, the coating of the designated material may be discontinued. For example, the designated material may include a polymer (or polymer) material. For example, the designated material may include a material with wear resistance (or with a low coefficient of friction) (or with low elongation). Each of the plurality of lines 611, 612 in the coating layer 525, 535 may be seen to extend towards or away from the third section 510, e.g. extend in a direction perpendicular to the folding axis f.

In an embodiment, the coating layer 525 or 535 of the FPCB 360 may be formed on an upper surface (e.g., a surface in a +z-axis direction, which may face a direction in which the display, e.g. display 230, is disposed) of the FPCB 360 or a lower surface (e.g., a surface in a -z-axis direction, which may face a direction in which a rear cover is disposed) of the FPCB 360.

For example, referring to FIG. 7A, in a structure in which the FPCB 360 has four conductive layers 711, 712, 713, and 714 and two protective layers 721 and 722, a coating layer (or one or more coating layer) may be disposed: above the protective layer 721 (e.g., a structure 701 of FIG. 7A), below the protective layer 722 (e.g., a structure 703 of FIG. 7A), or above the protective layer 721 and below the protective layer 722 (e.g., a structure 705 of FIG. 7A).

For example, an air gap 710 may be defined between the four conductive layers 711, 712, 713, and 714. For example, the air gap 710 may be defined as the conductive layer 712 and the conductive layer 713 are physically separated.

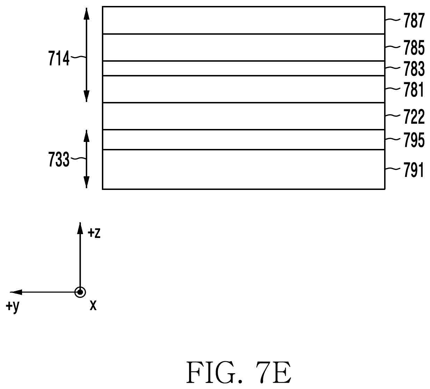

Referring to FIG. 7B, for example, the conductive layer 711 of the four conductive layers 711, 712, 713, and 714 may have a structure in which a Polyimide (PI) film layer 757 (e.g., approximately 12 micrometers), a copper layer 755 (e.g., approximately 12 micrometers), a copper plating layer 753 (e.g., approximately 15 micrometers) (or a copper-laminate adhesive layer), and a copper-laminate layer 751 (e.g., approximately 12.5 micrometers) are laminated in a height direction (e.g., the +z-axis direction). Referring to FIG. 7E, for example, the conductive layer 714 of the four conductive layers 711, 712, 713, and 714 may have a structure in which a PI film layer 787 (e.g., approximately 12 micrometers), a copper layer 785 (e.g., approximately 12 micrometers), a copper plating layer 783 (e.g., approximately 15 micrometers) (or the copper-laminate adhesive layer), and a copper-laminate layer 781 (e.g., approximately 12.5 micrometers) are laminated in a direction (e.g., the -z-axis direction) opposite to the conductive layer 711.

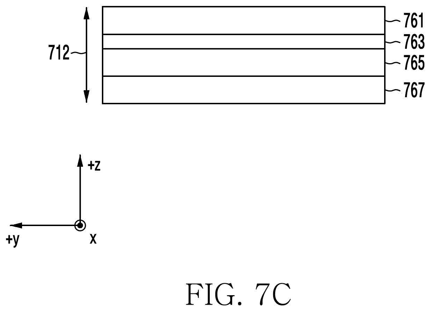

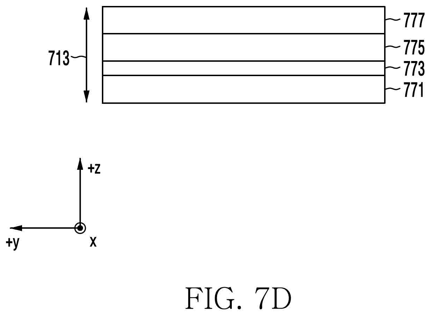

Referring to FIG. 7C, for example, the conductive layer 712 of the four conductive layers 711, 712, 713, and 714 may have a structure in which a PI film layer 767 (e.g., approximately 12 micrometers), a copper layer 765 (e.g., approximately 18 micrometers), a copper plating layer 763 (e.g., approximately 15 micrometers) (or the copper-laminate adhesive layer), and a copper-laminate layer 761 (e.g., approximately 7.5 micrometers) are laminated in the height direction (e.g., the +z-axis direction). Referring to FIG. 7D, for example, the conductive layer 713 of the four conductive layers 711, 712, 713, and 714 may have a structure in which a PI film layer 777 (e.g., approximately 12 micrometers), a copper layer 775 (e.g., approximately 18 micrometers), a copper plating layer 773 (e.g., approximately 15 micrometers) (or the copper-laminate adhesive layer), and a copper-laminate layer 771 (e.g., approximately 7.5 micrometers) are laminated in a direction (e.g., the -z-axis direction) opposite to the conductive layer 712.

In an embodiment, each of the protective layers 721 and 722 may be a layer having a thickness of approximately 12 micrometers. For example, the protective layers 721 and 722 may be an electromagnetic interference shielding layer for reducing electromagnetic interference. For example, the protective layers 721 and 722 may include a conductive material (e.g., metal).

For example, in the structure 701 of FIG. 7A, a coating layer 731 may be disposed above the protective layer 721 (e.g., in the +z-axis direction). For example, referring to FIG. 7B, the coating layer 731 may have a structure in which an adhesive layer 745 (e.g., approximately 3 micrometers) and an elastic layer 741 (e.g., approximately 15 micrometers) are laminated in the height direction (e.g., the +z-axis direction). For example, the adhesive layer 745 may be referred to as a primer. For example, the adhesive layer 745 may include a polymer polymer (e.g., an epoxy resin or an acrylic resin). For example, the coating layer 731 may be attached on the protective layer 721 via the adhesive layer 745 of the FPCB 360. In various examples, rather than explicitly identifying an adhesive layer 745, it may be considered that the coating layer 731 is simply adhered or applied to the protective layer 721.

For example, the elastic layer 741 may include a material with elasticity, e.g. an elastic material. For example, the elastic layer 741 may include a polymer (or polymer) material. For example, the elastic layer 741 may include a material with wear resistance (or with a low coefficient of friction) (or with low elongation). For example, the elastic layer 741 may include polytetrafluoroethylene (PTFE), urethane (or polyurethane), or Fluorinated Polyurethane. However, an embodiment is not limited thereto. The elastic layer 741 may include a hydrophobic (or water repellent) coating agent (e.g., a mixture of hydrofluoroether (HFE) and a fluorine-based acrylic polymer).

For example, in the structure 703 of FIG. 7A, the coating layer 733 may be disposed below the protective layer 722 (e.g., in the -z-axis direction). For example, referring to FIG. 7E, the coating layer 733 may have a structure in which an adhesive layer 795 (e.g., approximately 3 micrometers) and an elastic layer 791 (e.g., approximately 15 micrometers) are laminated in a direction (e.g., the -z-axis direction) opposite to a direction in which the adhesive layer 745 and the elastic layer 741 are laminated in the coating layer 731. For example, the coating layer 733 may be attached below the protective layer 722 via an adhesive layer of the FPCB 360. In various examples, rather than explicitly identifying an adhesive layer 795, it may be considered that the coating layer 733 is simply adhered or applied to the protective layer 722.

For example, the elastic layer 791 may include a material with elasticity. For example, the elastic layer 791 may include a polymer (or polymer) material. For example, the elastic layer 791 may include a material with wear resistance (or with a low coefficient of friction) (or with low elongation). For example, the elastic layer 791 may include polytetrafluoroethylene (PTFE), urethane (or polyurethane), or Fluorinated Polyurethane. However, an embodiment is not limited thereto. The elastic layer 791 may include a hydrophobic (or water repellent) coating agent (e.g., a mixture of hydrofluoroether (HFE) and a fluorine-based acrylic polymer).

For example, in the structure 705 of FIG. 7A, the coating layer 731 may be correspond to the coating layer 731 in the structure 701 of FIG. 7A. For example, in the structure 705 of FIG. 7A, the coating layer 733 may be correspond to the coating layer 733 in the structure 703 of FIG. 7A.

According to an embodiment, in the structures 701, 703, and 705 of FIG. 7A, the protective layer 721 or 722 may be replaced with the coating layer. In a case that the protective layer 721 or 722 is replaced with the coating layer, the coating layers 731 and 733 may be omitted from the structures 701, 703, and 705 of FIG. 7A, respectively. Accordingly, in a case that the protective layer 721 or 722 is replaced with the coating layer, the coating layer instead of the protective layer 721 may be disposed on the conductive layer 711 among the four conductive layers 711, 712, 713, and 714, and/or the coating layer instead of the protective layer 722 may be disposed below the conductive layer 714.

In an embodiment, the bending portion in the first portion 361 may include a first section 520, a second section 530, and a third section 510. For example, the third section 510 may be located between the first section 520 and the second section 530. For example, the third section 510 may intersect the folding axis f. The third section 510 may be regarded as overlapping or being defined around the folding axis f; for example the third section 510 may include a portion of the bending portion along which the folding axis extends. For example, as the FPCB 360 in the third section 510 is not in contact with other instruments (e.g. the first hinge plate 452, the second hinge plate 453, the first support member 412, the second support member 413, and the hinge cover 411), the coating layer may not be formed in the third section 510.

For example, a designated material may be coated on at least one surface of surfaces of the first section 520 of the FPCB 360 in contact with the instrument and/or a designated material (i.e. the same designated material or a different designated material) may be coated on at least one surface of surfaces of the second section 530 of the FPCB 360 in contact with the instrument.

In an embodiment, a coating layer may be disposed in at least portions of the FPCB 360 in contact with the instrument(s) (e.g. the first hinge plate 452, the second hinge plate 453, the first support member 412, the second support member 413, and the hinge cover 411).

For example, referring to FIG. 8A, when the electronic device 300 moves between an unfolded state 401 and a folded state 407 (that is, for an electronic device 300 capable of moving between an unfolded state 401 and a folded state 407) , a coating layer may be disposed in portions 812 and 832 where a first hinge plate 452 and the FPCB 360 contact each other. For example, as the FPCB 360 is disposed below the first hinge plate 452, the coating layer may be disposed on the first surface 801 (or a surface in the +z-axis direction) of the FPCB 360 (or disposed at least on the portions 812 and 832 of the FPCB 360). For example, a width (e.g., a length in the y-axis direction) of the coating layer in the portion 812 may correspond to a length (e.g., approximately 3.5 millimeters to 4 millimeters) that the first hinge plate 452 and the FPCB 360 contact each other. For example, the size of the coating layer in the portion 812 is based on the size of a first contact region on the FPCB 360, being a region where the FPCB 360 is contacted by the first hinge plate 452 at portion 812.

Likewise, for example, referring to FIG. 8A, when the electronic device 300 moves between the unfolded state 401 and the folded state 407 (that is, for an electronic device 300 capable of moving between an unfolded state 401 and a folded state 407), a coating layer may be disposed in portions 813 and 833 where a second hinge plate 453 and the FPCB 360 contact each other. For example, as the FPCB 360 is disposed below the second hinge plate 453, the coating layer may be disposed on the first surface 801 (or a surface in the +z-axis direction) of the FPCB 360 (or disposed at least on the portions 813 and 833 of the FPCB 360). For example, a width (e.g., a length in the y-axis direction) of the coating layer in the portion 813 may correspond to a length (e.g., approximately 3.5 millimeters to 4 millimeters) that the second hinge plate 453 and the FPCB 360 contact each other. For example, the size of the coating layer in the portion 813 is based on the size of a second contact region on the FPCB 360, being a region where the FPCB 360 is contacted by the first hinge plate 453 at portion 813.

Hereinafter, a coating layer disposed on the first surface 801 (or a surface in the +z-axis direction) of the FPCB 360 may be referred to as a first coating layer.

For example, the first coating layer may extend in a direction (e.g., the y-axis direction) perpendicular to the folding axis f according to the designated pattern. This direction may be termed a longitudinal direction.

For example, referring to FIG. 8A, when the electronic device 300 moves between the unfolded state 401 and the folded state 407 (that is, for an electronic device 300 capable of moving between an unfolded state 401 and a folded state 407), a coating layer may be disposed in the portion 822 where the first support member 412 and the FPCB 360 contact each other (or are expected to contact each other due to the folding or unfolding). For example, as the FPCB 360 is disposed on the first support member 412, the coating layer may be disposed on a second surface 802 (or a surface in the -z-axis direction) of the FPCB 360 (or the portion 822). For example, a width (e.g., a length in the y-axis direction) of the coating layer in the portion 822 may correspond to a length (e.g., approximately 7.5 millimeters) that the first support member 412 and the FPCB 360 contact each other. For example, the size of the coating layer in the portion 822 is based on the size of a third contact region on the FPCB 360, being a region where the FPCB 360 is contacted by the first support member 412 at portion 822.

Likewise, for example, referring to FIG. 8A, when the electronic device 300 moves between the unfolded state 401 and the folded state 407 (that is, for an electronic device 300 capable of moving between an unfolded state 401 and a folded state 407), a coating layer may be disposed in the portion 823 where the second support member 413 and the FPCB 360 contact each other (or are expected to contact each other due to the folding or unfolding). For example, as the FPCB 360 is disposed on the second support member 413, the coating layer may be disposed on the second surface 802 (or a surface in the -z-axis direction) of the FPCB 360 (or the portion 823). For example, a width (e.g., a length in the y-axis direction) of the coating layer in the portion 823 may correspond to a length (e.g., approximately 7.5 millimeters) that the second support member 413 and the FPCB 360 contact each other. For example, the size of the coating layer in the portion 823 is based on the size of a fourth contact region on the FPCB 360, being a region where the FPCB 360 is contacted by the second support member 413 at portion 823.

Hereinafter, a coating layer disposed on the second surface 802 (or a surface in the -z-axis direction) of the FPCB 360 may be referred to as a second coating layer.

For example, the second coating layer may extend in a direction (e.g., the y-axis direction) perpendicular to the folding axis f according to the designated pattern. This second coating layer may extend in the longitudinal direction.

In an embodiment, when the FPCB 360 is viewed from above (or when viewed in the z-axis direction), e.g. with the electronic device 300 being in the unfolded state 401, the first coating layer may be spaced apart from the second coating layer. For example, when the FPCB 360 is viewed from above (or when viewed in the z-axis direction), the first coating layer may not overlap the second coating layer. However, an embodiment is not limited thereto. For example, when the FPCB 360 is viewed from above (or when viewed in the z-axis direction), the first coating layer may at least partially overlap the second coating layer.

For example, referring to FIG. 8B, when the electronic device 300 moves between the unfolded state 401 and the folded state 407 (that is, for an electronic device 300 capable of moving between an unfolded state 401 and a folded state 407), a coating layer may be disposed in portions 842 and 843 where the hinge plates 452 and 453 and the FPCB 360 contact each other. For example, as the FPCB 360 is disposed below the hinge plates 452 and 453, the coating layer may be disposed on the first surface 801 (or a surface in the +z-axis direction) of the FPCB 360 (or at least on the portions 842 and 843). For example, a width (e.g., a length in the y-axis direction) of the coating layer in the portions 842 and 843 may correspond to a length (e.g., approximately 6.5 millimeters) that the first hinge plate 452 and the FPCB 360 contact each other. For example, the size of the coating layer in the portions 842, 843 is based on the size of fifth contact regions on the FPCB 360, being regions where the FPCB 360 is contacted by the hinge plates 452, 453 at portions 842, 843, respectively.

For example, the portions 842 and 843 where the hinge plates 452 and 453 in which the coating layer is disposed and the FPCB 360 contact each other, in the fully folded state 407 of the electronic device 300, may be located on the different surfaces 801 and 802 of the FPCB 360 from the portions 822 and 823 where the first and second support members 412 and 413 in which the coating layer is disposed and the FPCB 360 contact each other, in the unfolded state 401 of the electronic device 300. For example: in or with regards to the portions 842 and 843, a coating layer may be disposed on the first surface 801; and in or with regards to the portions 822 and 823, a coating layer may be disposed on the second surface 802. For example, when the FPCB 360 is viewed from above (or when viewed in the z-axis direction), a coating layer in the portions 842 and 843 may not overlap a coating layer in the portions 822 and 823.

For example, referring to FIG. 8B, when the electronic device 300 moves between the unfolded state 401 and the folded state 407 (that is, for an electronic device 300 capable of moving between an unfolded state 401 and a folded state 407), a coating layer may be disposed in portions 852 and 853 where the center plate 451 and the FPCB 360 contact each other. For example, as the FPCB 360 is disposed below the center plate 451, the coating layer may be disposed on the first surface 801 (or a surface in the +z-axis direction) of the FPCB 360 (or at least on the portions 852 and 853). For example, a width (e.g., a length in the y-axis direction) of the coating layer in the portions 852 and 853 may correspond to a length (e.g., approximately 2.8 millimeters) that the center plate 451 and the FPCB 360 contact each other. For example, the size of the coating layer in the portions 852, 853 is based on the size of sixth contact regions on the FPCB 360, being regions where the FPCB 360 is contacted by the center plate 451 at portions 852, 853. In various examples, the FPCB 360 includes a first coating layer comprising portions 812, 832, 842 and 852, a second coating layer comprising portions 813, 833, 843 and 853. In other examples, the FPCB 360 includes individual coating layers corresponding to each of portions 812, 813, 832, 833, 842, 843, 852 and 853, with non-coating regions of FPCB 360 between each neighbouring portion. In other words, two or more portions can be provided by a single, continuous coating layer disposed on the FPCB 360, or the coating layer(s) may be applied discontinuously such that there are gaps in the coating layer(s) between neighbouring portions.

According to an embodiment, a coating layer may be disposed in curved portions (e.g., one or more portions 441, 443, and 445 of FIG. 4A) of the FPCB 360. For example, the coating layer may be disposed on a convex surface among the convex surface and a concave surface of the curved portions (e.g., the one or more portions 441, 443, and 445 of FIG. 4A) of the FPCB 360. For example, the coating layer may be disposed in portions including a point where a curvature of the FPCB 360 has a maximum value (or a local maximum value). The coating layer may be disposed on a convex surface among the convex surface and a concave surface of the portions including the point where the curvature of the FPCB 360 has the maximum value (or the local maximum value).

As described above, a wear-resistant (or an elastic) material (or a material with a low coefficient of friction) (or a material with low elongation) is applied to a portion capable of being in contact with instrument (e.g. a component or part thereof as defined in the examples above), so the FPCB 360 may reduce deterioration of the FPCB 360 due to contact with instruments (e.g., the first hinge plate 452, the second hinge plate 453, the first support member 412, the second support member 413, and the hinge cover 411), generated as the first housing part 310 (or the first support member 412) of the electronic device 300 rotates with respect to the second housing part 320 (or the second support member 413).

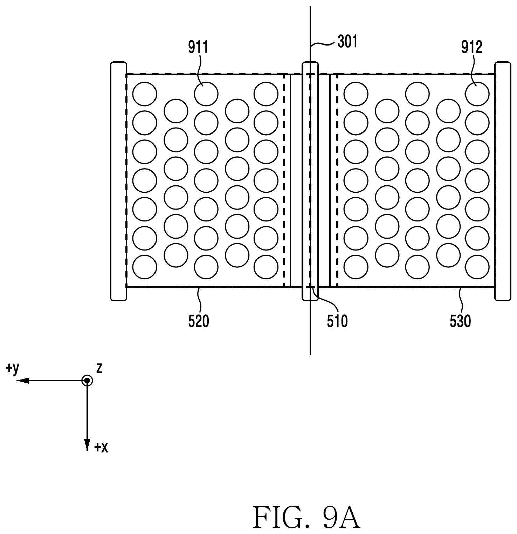

FIGS. 9A to 9C are a diagram exemplifying a pattern of a protective layer in an FPCB, according to an embodiment.

Referring to FIGS. 9A to 9C, compared to the pattern (e.g., the meander line pattern) of the coating layer of FIG. 6, a coating layer of an FPCB 360 may have a pattern in which a designated design, shape or figure (e.g., a circle 911 or 912), a triangle 921 or 922, and a square 931 or 932) is repeated.

For example, a coating layer of FIG. 9A may be formed in a pattern in which the circles 911 and 912 having the same size are arranged in a hexagonal tiling. For example, a pattern of the coating layer of FIG. 9A may have a pattern in which six circles are adjacent to (e.g. surround) one circle in each of a first section 520 and a second section 530 (except at the edges of the first section 520 and the second section 530, at which a circle may be adjacent to fewer circles as can be seen in FIG. 9A). For example, in the pattern of the coating layer of FIG. 9A, the circles 911 may be adjacent to each other through a gap of a designated length. For example, in the pattern of the coating layer of FIG. 9A, the circles 912 may be adjacent to each other through a gap of a designated length. However, an embodiment is not limited thereto. For example, in the pattern of the coating layer of FIG. 9A, the circles 911 may touch each other without the gap of the designated length. For example, in the pattern of the coating layer of FIG. 9A, the circles 912 may touch each other without the gap of the designated length.

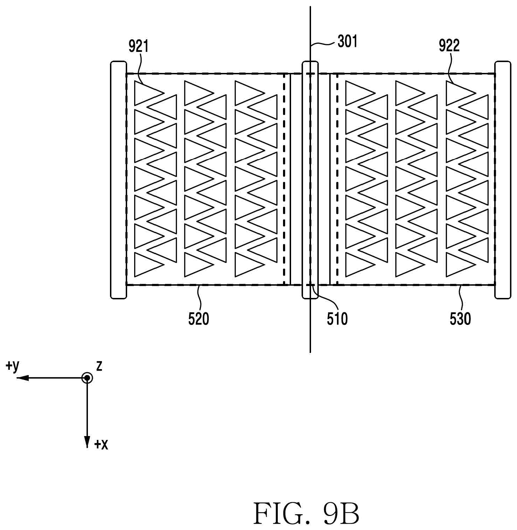

For example, a coating layer of FIG. 9B may be formed in a pattern in which the triangles 921 and 922 having the same size are arranged in a triangular tiling (or triangular grid arrangement). For example, a pattern of the coating layer of FIG. 9B may have a pattern in which three or more triangles are adjacent to (e.g. surround) one triangle in each of the first section 520 and the second section 530 (except at the edges of the first section 520 and the second section 530, at which a triangle may be adjacent to fewer triangles as can be seen in FIG. 9B). For example, in the pattern of the coating layer of FIG. 9B, the triangles 921 may be adjacent to each other as sides of the triangles 921 are spaced apart by a gap of a designated length. For example, in the pattern of the coating layer of FIG. 9B, the triangles 922 may be adjacent to each other as sides of the triangles 922 are spaced apart by a gap of a designated length.

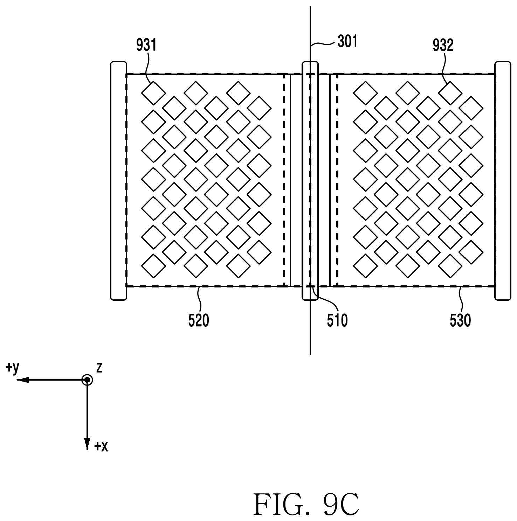

For example, a coating layer of FIG. 9C may be formed in a pattern in which the squares 931 and 932 having the same size are arranged in a square tiling (or square grid arrangement). For example, a pattern of the coating layer of FIG. 9C may have a pattern in which at least four squares are adjacent to (e.g. surround) one square in each of the first section 520 and the second section 530 (except at the edges of the first section 520 and the second section 530, at which a square may be adjacent to fewer squares as can be seen in FIG. 9C). For example, in the pattern of the coating layer of FIG. 9C, the squares 931 may be adjacent to each other as sides of the squares 931 are spaced apart by a gap of a designated length. For example, in the pattern of the coating layer of FIG. 9C, the squares 932 may be adjacent to each other as sides of the squares 932 are spaced apart by a gap of a designated length .

For example, when the FPCB 360 is viewed from above (e.g., when viewed in the z-axis direction), the coating layer of FIGS. 9A to 9C may be discontinued in a third section 510 intersecting a folding axis f. For example, the coating layer of FIGS. 9A to 9C may be discontinued in the third section 510 intersecting the folding axis f among a portion where a center plate (e.g., 451 of FIG. 4A) and the FPCB 360 overlap.

According to an embodiment, coating layers having different patterns may be disposed in the first section 520 and the second section 530. For example, in the first section 520, the coating layer according to the pattern of FIG. 6 may be disposed, and in the second section 530, the coating layer according to the pattern of FIG. 9A may be disposed. In other words, various embodiments of the present disclosure provide different designated patterns in different coating layers of the FPCB 360 (e.g. any of portions 812, 822, 832, 842, 852, 813, 823, 833, 843, 853) or in different sections of the FPCB 360 (e.g. first section 520 and second section 530)

The patterns exemplified through FIGS. 9A to 9C are merely an example. For example, various patterns may be formed on the first section 520 and the second section 530.

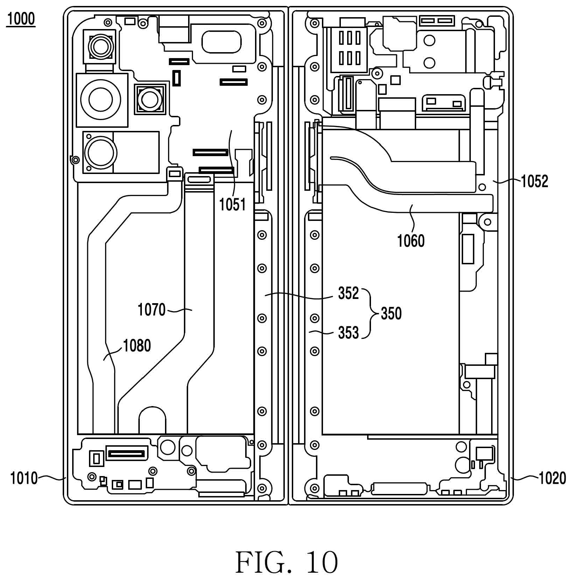

FIG. 10 is a diagram indicating an example of an electronic device to which an FPCB having a protective layer is applied, according to an embodiment.

FIG. 10 is a front view of an electronic device 1000 from which a display (e.g., the display 230 of FIG. 2A) is removed. Referring to FIG. 10, the electronic device 1000 according to an embodiment may include one or more FPCBs 1060, 1070, and 1080.

In an embodiment, the FPCB 1060 of the electronic device 1000 may extend from a first housing part 1010 to a second housing part 1020. In an embodiment, the FPCB 1060 may extend from the first housing part 1010 to the second housing part 1020, beyond a hinge structure 350 disposed between the first housing part 1010 and the second housing part 1020.

In an embodiment, a portion (e.g., the first portion 361 of FIG. 3) of the FPCB 1060 may be disposed below the hinge structure 350, where the hinge structure 350 includes a first support member 352 and a second support member 353. In an embodiment, a coating layer may be disposed in at least one surface among surfaces of the portion (e.g., the first portion 361 of FIG. 3) of the FPCB 1060 (e.g. according to any one of the examples described above/herein).

According to an embodiment, a coating layer may be disposed on surfaces of other components in the electronic device 1000. For example, a coating layer may also be disposed on printed circuit boards 1051 and 1052. For example, a pattern of the coating layer disposed on the printed circuit boards 1051 and 1052 may have at least one pattern of the patterns according to FIGS. 6 and 9A to 9C. For example, a coating layer may also be disposed on the FPCBs 1070 and 1080. For example, a pattern of the coating layer disposed on the FPCBs 1070 and 1080 may have at least one pattern of the patterns according to FIGS. 6 and 9A to 9C. However, an embodiment is not limited thereto. For example, in order to prevent (or reduce) an impact between components in the electronic device 1000, a coating layer may be disposed on a surface of the components. As the coating layer is disposed on the surface of the components, even in a case that contact between instruments occurs by pressure (e.g., pressure from a rear surface of the electronic device 1000 toward the electronic device 1000, or pressure by rotation of the housing parts 1010 and 1020 of the electronic device 1000) on the electronic device 1000, it may prevent (or reduce) an impact of the instruments and prevent (or reduce) deterioration of the instruments.

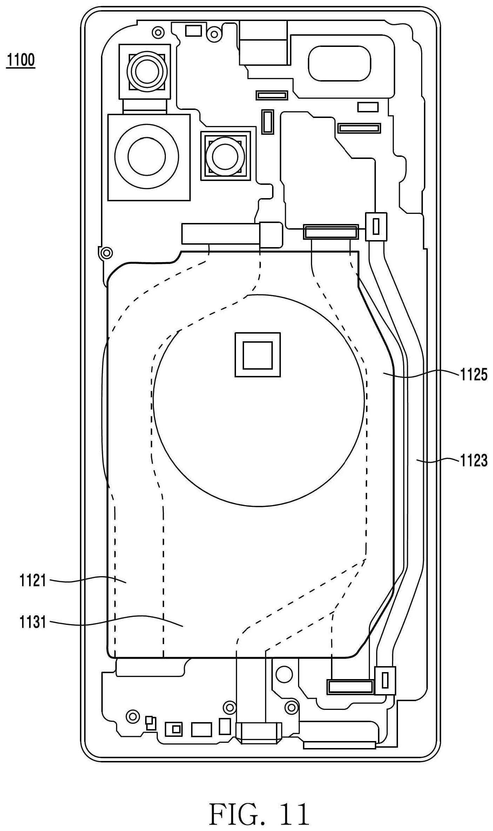

FIG. 11 is a diagram indicating an example of an electronic device to which an FPCB having a protective layer is applied, according to an embodiment.

FIG. 11 is a front view of an electronic device 1100 from which a rear cover is removed. The electronic device 1100 of FIG. 11 may be a bar-type electronic device having a form factor different from that of the electronic device 300 of FIG. 3.

Referring to FIG. 11, the electronic device 1100 according to an embodiment may include FPCBs 1121, 1123, and 1125.

In an embodiment, a coating layer 1131 may be disposed on the FPCBs 1121, 1123, and 1125 of the electronic device 1100. For example, the coating layer 1131 may cover a region including the FPCBs 1121, 1123, and 1125. For example, the coating layer 1131 may also be disposed on surfaces of components (e.g., a battery and a printed circuit board) of the electronic device 1100 other than the FPCBs 1121, 1123, and 1125. For example, the coating layer 1131 may have at least one pattern of the patterns according to FIGS. 6 and 9A to 9C.

As the coating layer 1131 covers the region including the FPCBs 1121, 1123, and 1125, even in a case that contact between instruments occurs by pressure (e.g., pressure from a rear surface of the electronic device 1100 toward the electronic device 1100) on the electronic device 1100, it may prevent (or reduce) an impact of the instruments and prevent (or reduce) deterioration of the instruments.

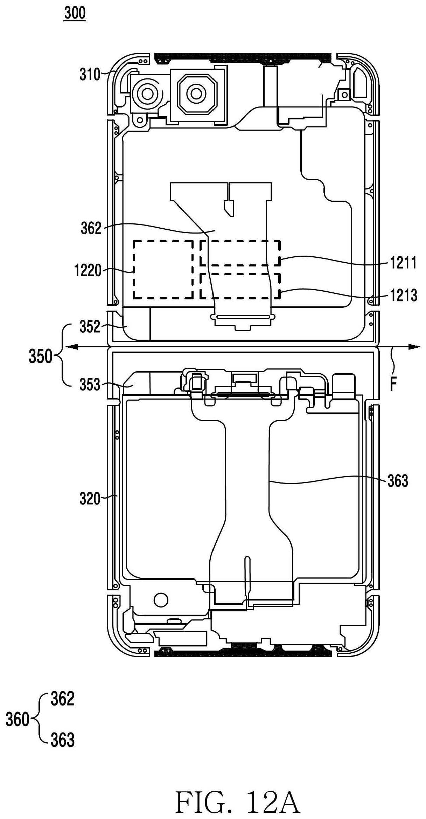

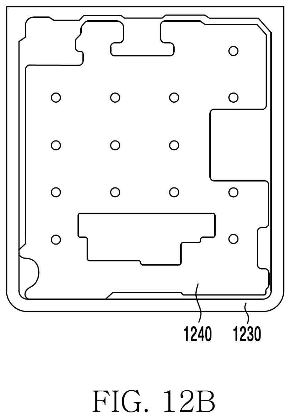

FIGS. 12A and 12B are a diagram indicating an example of an electronic device in which a protective layer is applied to a region other than an FPCB, according to an embodiment.

FIG. 12A is a front view of an electronic device 300 from which a display (e.g., the display 230 of FIG. 2A) is removed. FIG. 12B indicates a rear cover 1230 of the electronic device 300.

Referring to FIG. 12A, a coating layer may also be disposed in portions (e.g., a second portion 362) other than a first portion (e.g., 361 of FIG. 3) of an FPCB 360. For example, the coating layer may be disposed to replace an impact-absorbing material (e.g., a sponge) in the portions (e.g., the second portion 362) other than the first portion (e.g., 361 of FIG. 3) of the FPCB 360. For example, referring to FIG. 12A, the coating layer may be disposed in specific regions 1211 and 1213 in the second portion 362. For example, the coating layer disposed in the specific regions 1211 and 1213 may have at least one pattern of the patterns according to FIGS. 6 and 9A to 9C.

Referring to FIG. 12A, the coating layer may also be disposed in a portion 1220 of an instrument other than the FPCB 360. For example, referring to FIG. 12B, a coating layer 1240 may be (overall) disposed in the rear cover 1230. For example, the coating layer may be disposed to replace an impact-absorbing material (e.g., a sponge) in the portion 1220 of the instrument. For example, the coating layer disposed in the portion 1220 of the instrument may have at least one pattern of the patterns according to FIGS. 6 and 9A to 9C.

The effects that can be obtained from the present disclosure are not limited to those described above, and any other effects not mentioned herein will be clearly understood by those having ordinary knowledge in the art to which the present disclosure belongs, from the following description.

The electronic device 300 as described above may include a foldable housing including a first housing part 310 and a second housing part 320 rotatable with respect to the first housing part 310, and a flexible printed circuit board (FPCB) 360 including a bending portion bending when the foldable housing is folded. The FPCB may include coating layers 731 and 733 in the bending portion. The coating layers 731 and 733 in the bending portion of the FPCB may define at least one surface of a first surface and a second surface of the FPCB 360, and may include an elastic material extending according to a designated pattern.

The bending portion of the FPCB 360 may include a first section 520, a second section 530, and a third section 510 located between the first section 520 and the second section 530, the third section 510 intersecting a folding axis of the foldable housing. The coating layer 731 or 733 may include a first coating layer 731 or 733 defining the at least one surface in the first section 520, and a second coating layer 731 or 733 defining the at least one surface in the second section 530.

The first coating layer 731 or 733 may extend in a direction perpendicular to the folding axis according to the designated pattern, and the second coating layer 731 or 733 may extend in the perpendicular direction to the folding axis according to the designated pattern.

The designated pattern may be a meander line pattern.

The designated pattern may be a pattern where circles having the same size are arranged in a hexagonal tiling.

The coating layer 731 or 733 may include a first coating layer 731 defining the first surface of the FPCB 360, and a second coating layer 733 defining the second surface of the FPCB 360.

When the FPCB 360 is viewed from above (e.g. in an unfolded state such as state 401), the first coating layer 731 may be spaced apart from the second coating layer 733.

The electronic device 300 may include a flexible display 230 including a bending portion bending when the foldable housing is folded, and wing plates 452 and 453 disposed below the bending portion of the flexible display 230 to support the flexible display 230 and configured to bend the flexible display 230 into a designated shape when the foldable housing is folded. The FPCB 360 may be disposed below the wing plates 452 and 453. The coating layer 731 or 733 may be disposed in a region including a portion 812 or 813 where the wing plates 452 and 453 and the FPCB 360 contact each other when the foldable housing is folded.

The electronic device 300 may include a center plate 451 disposed between the wing plates 452 and 453 and below the bending portion of the flexible display 230 to support the flexible display 230, and configured to bend the flexible display 230 into the designated shape when the foldable housing is folded. The FPCB 360 may be disposed below the center plate 451, and the coating layer 731 or 733 may be disposed in a region including a portion 852 or 853 where the center plate 451 and the FPCB 360 contact each other when the foldable housing is folded.

When the FPCB 360 is viewed from above, the coating layer 731 or 733 may be discontinued at a section of an overlapping portion between the center plate 451 and the FPCB 360 that intersects the folding axis of the foldable housing.

The electronic device 300 may include a first support member 412 of the first housing part 310 and a second support member 413 of the second housing part 320, the first and second support members configured to rotate the wing plates 452 and 453 when the foldable housing is folded. The FPCB 360 may be disposed on the first support member 412 and the second support member 413, and the coating layer 731 or 733 may be disposed in a region including a portion 822 or 823 where the first and second support members 412 and 413 and the FPCB 360 contact each other when the foldable housing is fully unfolded.

A portion where the wing plates 452 and 453 and the FPCB 360 contact each other when the foldable housing is folded may be located on different surfaces of the FPCB 360 from a portion where the first and second support members 412 and 413 and the FPCB 360 contact each other when the foldable housing is fully unfolded.

The FPCB 360 may include a layer 721 or 722 for reducing electromagnetic interference. The coating layer 731 or 733 may be attached to the layer 721 or 722 via an adhesive layer 745 or 795 of the FPCB 360.

The coating layer 731 or 733 may include a water repellent material.

The coating layer 731 or 733 may include a urethane-based material.

The electronic device 300 as described above may include a foldable housing including a first housing part 310 and a second housing part 320 rotatable with respect to the first housing part 310, and a flexible printed circuit board (FPCB) 360 including a bending portion bending when the foldable housing is folded. The bending portion may include a first section 520 including a coating layer 731 or 733 defining a surface of the FPCB 360, and a second section 530 extending from the first section and intersecting a folding axis of the foldable housing, and the coating layer 731 or 733 may extend along a direction perpendicular to the folding axis according to a designated pattern in the first section 520 among the first section 520 and the second section 530.

The coating layer 731 or 733 may define at least one surface of a first surface and a second surface of the FPCB 360, and may include an elastic material.

The designated pattern may be a meander line pattern.

The coating layer 731 or 733 may include a first coating layer 731 defining the first surface of the FPCB 360, and a second coating layer 733 defining the second surface opposite to the first surface of the FPCB 360. When the FPCB 360 is viewed from above, the first coating layer 731 may be spaced apart from the second coating layer 733.

The electronic device 300 may include a flexible display 230 including a bending portion bending when the foldable housing is folded, and wing plates 452 and 453 disposed below the bending portion of the flexible display 230 to support the flexible display 230 and configured to bend the flexible display 230 into a designated shape when the foldable housing is folded. The FPCB 360 may be disposed below the wing plates 452 and 453, and the coating layer 731 or 733 may be disposed in a region including a portion 812 or 813 where the wing plates 452 and 453 and the FPCB 360 contact each other when the foldable housing is folded.

The effects that can be obtained from the present disclosure are not limited to those described above, and any other effects not mentioned herein will be clearly understood by those having ordinary knowledge in the art to which the present disclosure belongs, from the following description.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (300) comprising:
a foldable housing including a first housing part (310) and a second housing part (320) rotatable with respect to the first housing part (310); and
a flexible printed circuit board (FPCB) (360) including a bending portion configured to bend when the foldable housing is folded,
wherein the bending portion includes a coating layer (731, 733) configured to define at least one surface of a first surface and a second surface of the FPCB, and the coating layer includes an elastic material extending according to a designated pattern; and
wherein the coating layer is included on the bending portion of the FPCB in a location which is contactable with an internal structure of the electronic device by the folding or unfolding of the foldable housing.

2. The electronic device (300) of claim 1,
wherein the bending portion of the FPCB (360) includes:
a first section (520),
a second section (530), and
a third section (510) located between the first section (520) and the second section (530), the third section (510) intersecting a folding axis of the foldable housing, and
wherein the coating layer (731, 733) includes:
a first coating layer (731, 733) defining the at least one surface in the first section (520), and
a second coating layer (731, 733) defining the at least one surface in the second section (530).

3. The electronic device (300) of claim 2,
wherein the first coating layer (731, 733) and the second coating layer (731, 733) extend in a direction perpendicular to the folding axis according to the designated pattern.

4. The electronic device (300) of any one of the previous claims,
wherein the designated pattern is a meandering line pattern, or
wherein the designated pattern is a pattern of repeated shapes.

5. The electronic device (300) of claim 1,
wherein the coating layer (731, 733) includes:
a first coating layer (731) defining the first surface of the FPCB (360), and
a second coating layer (733) defining the second surface of the FPCB (360).

6. The electronic device (300) of claim 5,
wherein, when the electronic device (300) is viewed from above, the first coating layer (731) is spaced apart from the second coating layer (733).

7. The electronic device of any one of the previous claims, wherein the internal structure includes:
a hinge structure (350) configured to rotatably connect the first housing part (310) to the second housing part (320), and/or
at least one of a first support member (412) of the first housing part (310) or a second support member (413) of the second housing part (320), wherein the first support member (412) and the second support member (413) are disposed below the FPCB (360).

8. The electronic device (300) of claim 1 comprising:
a flexible display (230) including a bending portion configured to bend when the foldable housing is folded; and
wing plates (452, 453) disposed below the bending portion of the flexible display (230) to support the flexible display (230) and configured to bend the flexible display (230) into a designated shape when the foldable housing is folded,
wherein the FPCB (360) is disposed below the wing plates (452, 453), and
wherein the coating layer (731, 733) is disposed on the FPCB (360) in first portions (812, 813) where the wing plates (452, 453) and the FPCB (360) contact each other when the foldable housing is folded.

9. The electronic device (300) of claim 8, comprising:
a center plate (451) disposed between the wing plates (452, 453) and below the bending portion of the flexible display (230) to support the flexible display (230), and configured to bend the flexible display (230) into the designated shape when the foldable housing is folded,
wherein the FPCB (360) is disposed below the center plate (451), and
wherein the coating layer (731, 733) is disposed on the FPCB (360) in second portions (852, 853) where the center plate (451) and the FPCB (360) contact each other when the foldable housing is folded.

10. The electronic device (300) of claim 9,
wherein, when the electronic device (300) is viewed from above, the coating layer (731, 733) is discontinued at a section of the FPCB (360) that intersects the folding axis of the foldable housing.

11. The electronic device (300) of any one of claims 8 to 10, comprising:
a first support member (412) of the first housing part (310) and a second support member (413) of the second housing part (320), the first and second support members configured to rotate the wing plates (452, 453) when the foldable housing is folded,
wherein the FPCB (360) is disposed on the first support member (412) and the second support member (413), and
wherein the coating layer (731, 733) is disposed on the FPCB (360) in third portions (822, 823) where the first and second support members (412, 413) and the FPCB (360) contact each other when the foldable housing is unfolded.

12. The electronic device (300) of claim 11,
wherein the first portions are located on a different surface of the FPCB (360) from the third portions.

13. The electronic device (300) of any one of the previous claims,
wherein the FPCB (360) includes a layer (721, 722) for reducing electromagnetic interference.

14. The electronic device (300) of claim 1,
wherein the coating layer (731, 733) is attached to the layer (721, 722) via an adhesive layer (745, 795) of the FPCB (360).

15. The electronic device (300) of any one of the previous claims,
wherein the coating layer (731, 733) includes a water repellent material.
